# EUROPEAN PATENT APPLICATION

(11) **EP 4 723 812 A1**
(43) Date of publication of application: **08.04.2026**
(21) Application number: 24815871.9
(22) Date of filing: 30.05.2024
(51) Int. Cl.: H05K 1/14, H05K 3/28, H05K 1/11, H01L 23/498, G02F 1/1333

(54) **FLEXIBLE CIRCUIT BOARD MODULE AND ELECTRONIC DEVICE COMPRISING SAME**

(30) Priority: 30.05.2023 KR 20230069601
(71) Applicant: LG INNOTEK CO. LTD, Gangseo-gu Seoul 07796 (KR)
(72) Inventor: PARK, Ki Tae, Seoul 07796 (KR); KANG, Chae Won, Seoul 07796 (KR); SON, Man Ki, Seoul 07796 (KR)
(74) Representative: DREISS Patentanwälte PartG mbB
(86) International application number: PCT/KR2024/007385
(87) International publication number: WO 2024/248497

(57) **Abstract**

A flexible circuit board module according to an embodiment includes a first flexible circuit board and a second flexible circuit board, wherein the first flexible circuit board includes: a substrate; a power pattern and a test pattern disposed on the substrate; and a protective layer disposed on the power pattern and the test pattern, wherein the power pattern includes a first wiring pattern, a first-first pad pattern, and a first-second pad pattern, the first-first pad pattern is connected to a display panel, the first-second pad pattern is connected to a circuit board, and a first width of the first wiring pattern is 1 mm to 3 mm.

## Description

### [Technical Field]

An embodiment relates to a flexible circuit board module, and electronic device comprising same.

### [Background Art]

Recently, various electronic products are becoming thinner, smaller, and lighter. Accordingly, various studies are being conducted to mount semiconductor chips in a narrow region of electronic products at high density.

A chip-on-film (COF) uses a flexible substrate. Accordingly, the chip-on-film may be applied to a flexible display. Also, the chip-on-film may implement a fine pitch, and thus, a high-resolution display may be implemented by an increase in a number of pixels.

The chip-on-film mounts a semiconductor chip on a flexible circuit board in the form of a thin film. For example, the semiconductor chip may be an Integrated Circuit (IC) chip or a Large Scale Integrated Circuit (LSI) chip.

The chip may be connected to an external circuit board and a display panel through a circuit pattern. For example, pad parts are disposed at one end and the other end of the circuit pattern, respectively. One pad part is electrically connected to a terminal of the chip. In addition, the other pad part may be connected to terminals of the circuit board and the display panel. Accordingly, the chip, the circuit board, and the display panel are electrically connected by the chip-on film. Accordingly, a signal may be transmitted to the display panel by the circuit pattern.

In addition, the chip-on film includes a circuit pattern for supplying power to the circuit board or the display panel. A display panel requiring high power requires a plurality of power supply circuit patterns.

However, a space of the chip-on film is limited. Also, when the chip-on film includes a plurality of power supply circuit patterns, a size of the chip-on film may be larger than a size of the display panel.

Therefore, a flexible circuit board module with a new structure capable of solving the above problems and an electronic device including the same are required,

As a patent related to the above flexible circuit board, a Korean registered patent KR10-0618898 (2006.09.01) is disclosed..

### [Disclosure]

### [Technical Problem]

An embodiment provides a flexible circuit board module capable of efficiently supplying power to a large-area display panel.

### [Technical Solution]

A flexible circuit board module according to an embodiment includes a first flexible circuit board and a second flexible circuit board, wherein the first flexible circuit board includes: a substrate; a power pattern and a test pattern disposed on the substrate; and a protective layer disposed on the power pattern and the test pattern, wherein the power pattern includes a first wiring pattern, a first-first pad pattern, and a first-second pad pattern, the first-first pad pattern is connected to a display panel, the first-second pad pattern is connected to a circuit board, and a first width of the first wiring pattern is 1 mm to 3 mm.

### [Advantageous Effects]

A flexible circuit board module according to an embodiment includes a first flexible circuit board and a second flexible circuit board.

The first flexible circuit board includes a power pattern. Power can be stably supplied to a display panel by the power pattern.

The power pattern is connected to a plurality of pad patterns. Accordingly, a current flow efficiency of the power pattern is improved.

Furthermore, the first flexible circuit board includes a test pattern. The test pattern allows the first flexible circuit board to check the current flow before use. Accordingly, the reliability of the electronic device is improved.

Furthermore, the first flexible circuit board includes a first region and a second region. The first region can be bent. A layer structure of a wiring pattern overlapping the first region may be different from layer structures of the other regions. Accordingly, the bending reliability of the first flexible circuit board is improved.

The second flexible circuit board may omit the power supply pattern. Accordingly, a size of the second flexible circuit board can be reduced. In addition, the uniformity of the pattern disposed on the second flexible circuit board is improved.

### [Description of Drawings]

FIG. 1 is a plan view of an electronic device according to an embodiment.
FIG. 2 and FIG. 3 are views illustrating a connection relationship of an electronic device according to an embodiment.
FIG. 4 is a plan view of a first flexible circuit board according to an embodiment.
FIG. 5 is an enlarged view of region A of FIG. 4.
FIG. 6 is an enlarged view of region B of FIG. 4.
FIGS. 7 to 10 are cross-sectional views taken along region A-A' of FIG. 4.
FIGS. 11 and 12 are cross-sectional views taken along region B-B' and region C-C' of FIG. 4, respectively.
FIGS. 13 and 14 are cross-sectional views taken along region B-B' and region C-C' of FIG. 4, respectively.
FIGS. 15 and 16 are cross-sectional views taken along region B-B' and region C-C' of FIG. 4, respectively.
FIGS. 17 and 18 are cross-sectional views taken along the B-B' region and the C-C' region of Figure 4, respectively.
FIG. 19 is a plan view of a second flexible circuit board according to an embodiment.
FIG. 20 is another plan view of a second flexible circuit board according to an embodiment.
FIGS. 21 to 23 are drawings of electronic devices according to an embodiment.

### [Modes of the Invention]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and redisposed.

In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art. In addition, the terms used in the embodiments of the present disclosure are for describing the embodiments and are not intended to limit the present disclosure.

In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements.

Further, when expressed as "on (over)" or "under (below)", it may include not only the upper direction but also the lower direction based on one element.

In the following description, a first direction 1D is defined as a length (vertical) direction of the flexible circuit board. A second direction 2D is defined as a width (horizontal) direction of the flexible circuit board.

Hereinafter, a flexible circuit board module and an electronic device including the same according to an embodiment will be described with reference to the drawings.

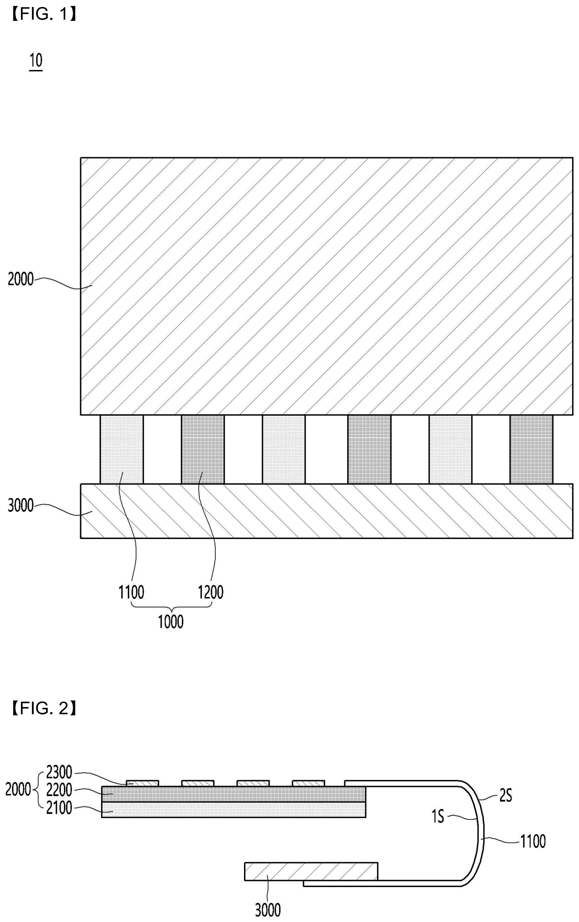

Referring to FIGS. 1 to 3, the electronic device 10 includes a flexible circuit board module 1000, a display panel 2000, and a circuit board 3000.

The display panel 2000 and the circuit board 3000 are connected. Specifically, the display panel 2000 and the circuit board 3000 are electrically connected by the flexible circuit board module 1000.

The display panel 2000 may include a display panel requiring high power.

The display panel 2000 may include a first panel 2100, a second panel 2200, and a plurality of light-emitting diodes 2300.

The second panel 2200 may be disposed on the first panel 2100. The flexible circuit board module 1000 may be connected to at least one of the first panel 2100 and the second panel 2200.

The light-emitting diode 2300 may include a micro LED. The light-emitting diode 2300 may be disposed on the first panel 2100 or the second panel 2200. For example, the light-emitting diode 2300 may be disposed on the second panel 2200. The flexible circuit board module 100 may be connected to the second panel 2200. Alternatively, the light-emitting diode 2300 may be disposed below the first panel 2100. The flexible circuit board module 1000 may be connected to the second panel 2200. Accordingly, an area where the light emitting diode 2300 can be disposed may increase.

The circuit board 3000 may include a rigid material. For example, the circuit board 3000 may include a printed circuit board (PCB).

The flexible circuit board module 1000 includes a first flexible circuit board 1100 and a second flexible circuit board 1200.

The first flexible circuit board 1100 includes a plurality of power wirings. The first flexible circuit board 1100 supplies power to at least one of the display panel 2000 and the circuit board 3000.

The second flexible circuit board 1200 includes a chip CH. The second flexible circuit board 1200 transmits signals between the display panel 2000 and the circuit board 3000. The second flexible circuit board 1200 may include a plurality of power lines. The second flexible circuit board 1200 may supply power to at least one of the display panel 2000 and the circuit board 3000. Alternatively, the second flexible circuit board 1200 may not include power lines.

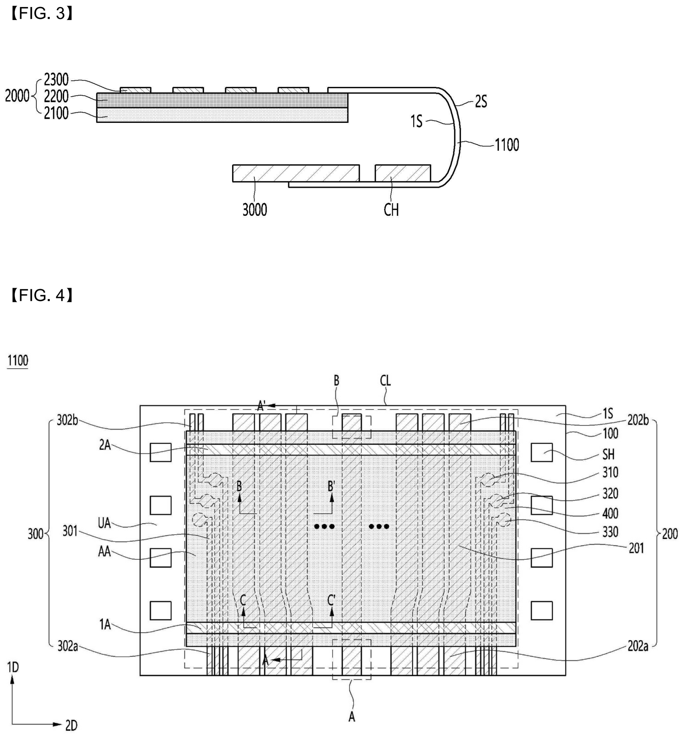

Hereinafter, the first flexible circuit board 1100 will be described with reference to FIGS. 4 to 12.

Referring to FIG. 4, the first flexible circuit board 1100 includes a substrate 100, a pattern, and a protective layer 400.

The substrate 100 includes a first surface 1S and a second surface 2S opposite the first surface 1S. The pattern and the protective layer 400 may be disposed on the first surface 1S.

The substrate 100 includes a cutting line CL. The first flexible circuit board 1100 is cut along the cutting line CL. For example, the pattern and the protective layer 400 are first disposed on the substrate 100. Subsequently, the substrate 100 is cut along the cutting line CL.

The substrate 100 includes a valid region AA and an invalid region UA. In detail, the first surface 1S includes the valid region AA and the invalid region UA.

The valid region AA and the invalid region UA are separated by the cutting line CL. In detail, the valid region AA is defined as an inner region of the cutting line CL. Furthermore, the invalid region UA is defined as an outer region of the cutting line CL.

The circuit pattern and the protective layer are disposed in the valid region AA. Furthermore, a dummy pattern and a sprocket hole SH are disposed in the invalid region UA. The dummy pattern increases the strength of the substrate 100. Furthermore, the flexible circuit board 1000 is rolled or unrolled in a roll-to-roll manner by the sprocket hole SH.

The substrate 100 includes a flexible material. For example, the substrate 100 may include polyimide (PI). However, the embodiment is not limited thereto. The substrate 100 may include a polymer material including polyethylene terephthalate (PET) or polyethylene naphthalate (PEN). Accordingly, the first flexible circuit board can be used in various electronic devices, including curved display devices. For example, since the first flexible circuit board has excellent flexibility, it can be applied to wearable electronic devices.

The substrate 100 may have a thickness of 20 µm to 100 µm. For example, the substrate 100 may have a thickness of 25 µm to 50 µm. For example, the substrate 100 may have a thickness of 30 µm to 40 µm. If the thickness of the substrate 100 exceeds 100 µm, the overall thickness of the first flexible circuit board increases. Accordingly, the flexibility characteristics of the first flexible circuit board may be reduced. Furthermore, if the thickness of the substrate 100 is less than 20 µm, the strength of the first flexible circuit board may be reduced.

The circuit pattern and the protective layer 400 are disposed on the substrate 100. Specifically, the circuit pattern and the protective layer 400 are disposed on the first surface 1S. Specifically, the circuit pattern and the protective layer 400 are disposed on at least one of the valid region AA and the invalid region UA.

The protective layer 400 may include a solder paste. For example, the protective layer 400 may include a solder paste containing a thermosetting resin, a thermoplastic resin, a filler, a curing agent, or a curing accelerator.

The circuit pattern includes a power pattern 200 and a test pattern 300.

The power pattern 200 includes a first wiring pattern 201, a first-first pad pattern 202a, and a first-second pad pattern 202b. The first wiring pattern 201, the first-first pad pattern 202a, and the first-second pad pattern 202b include a same material. The first wiring pattern 201, the first-first pad pattern 202a, and the first-second pad pattern 202b are formed integrally.

The first-first pad pattern 202a is disposed outside the protective layer 400. The first-first pad pattern 202a can be connected to the display panel 2000. Thus, the first flexible circuit board 1100 is connected to the display panel 2000.

The first-second pad pattern 202b is disposed outside the protective layer 400. The first-second pad pattern 202b can be connected to the circuit board 3000. Thus, the first flexible circuit board 1100 is connected to the circuit board 3000.

The first wiring pattern 201 is disposed between the first-first pad pattern 202a and the first-second pad pattern 202b. The first wiring pattern 201 connects the first-first pad pattern 202a and the first-second pad pattern 202b. The first wiring pattern 201 is a pattern through which current flows. Accordingly, power is supplied to the display panel 2000 and the circuit board 3000 via the first wiring pattern 201.

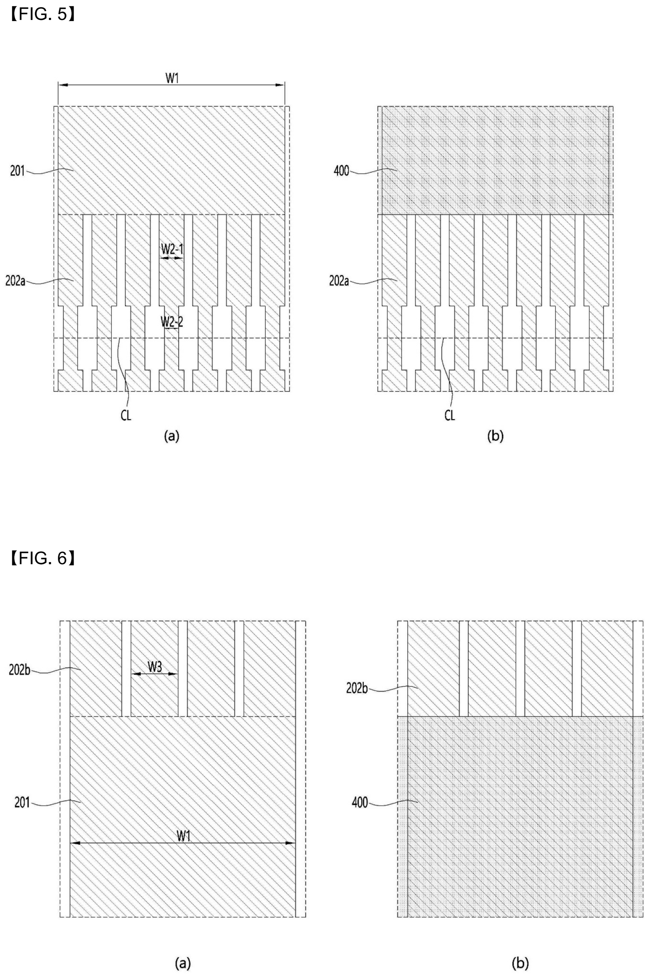

FIG. 5 is an enlarged view of region A of FIG. 4. FIG. 5 (a) is a view omitting the protective layer 400, and FIG. 5 (b) is a view illustrating the protective layer 400.

Referring to FIG. 5, one first wiring pattern 201 can be connected to a plurality of first-first pad patterns 202a. This improves the efficiency of current flowing to the display panel 2000.

Specifically, since a plurality of first-first pad patterns 202a are merged into one first-first wiring pattern 201, a current transfer area can be expanded. Furthermore, the uniformity of current flowing through a plurality of first-first pad patterns 202a can be improved. Accordingly, the current transfer efficiency of the first flexible circuit board 1100 can be improved.

The first-first wiring pattern 201 is formed with a set width. Specifically, a width W1 of the first-first wiring pattern 201 can be 1 mm or greater. Specifically, the width W1 of the first-first wiring pattern 201 can be 1 mm to 3 mm, 1.1 mm to 2.5 mm, or 1.3 mm to 2 mm.

If the width W1 of the first-first wiring pattern 201 is less than 1 mm, a number of merged first-first pad patterns 202a is reduced. Accordingly, the current transmission efficiency of the first flexible circuit board may decrease. Furthermore, the number of first wiring patterns 201 disposed on the substrate 100 increases. As the number of first wiring patterns 201 increases, a spacing between the first wiring patterns 210 also increases. Accordingly, the size of the first flexible circuit board may increase.

If the width W1 of the first wiring pattern 201 exceeds 3 mm, the number of merged first-first pad patterns 202a increases. Accordingly, first-first pad patterns 202a transmitted to different regions may be merged into one first-first wiring pattern 201. Consequently, interference of current transmitted to different regions may occur.

The first-first pad pattern 202a is formed with a set width. The first-first pad pattern 202a has a second-first width W2-1 and a second-second width W2-2. The second-first width W2-1 is a long width of the first-first pad pattern 202a. The second-first width W2-1 may be 15 µm or greater. Specifically, the second-first width W2-1 may be 15 µm to 25 µm, 17 µm to 23 µm, or 19 µm to 21 µm.

The first-first pad pattern 202a can be merged into a plurality of first-first pad patterns 202a so that the first wiring pattern 201 can satisfy the range of the width.

The second-second width W2-2 is a short width of the first-first pad pattern 202a. The second-second width W2-2 may be 5 µm or greater. Specifically, the second-second width W2-2 may be 3 µm to 14 µm, 5 µm to 13 µm, or 7 µm to 12 µm.

The power pattern 200 is cut by the cutting line CL. Specifically, a partial region of the first-first pad pattern 202a is cut by the cutting line CL. The first-first pad pattern 202a includes a region with a small width. Accordingly, the first-first pad pattern 202a can be easily cut along the cutting line CL.

FIG. 6 is an enlarged view of region B of FIG. 4. FIG. 6 (a) is a view omitting the protective layer 400, and FIG. 6 (b) is a view illustrating the protective layer 400.

Referring to FIG. 6, one first wiring pattern 201 can be connected to a plurality of first-second pad patterns 202b. This improves the efficiency of current flowing to the circuit board 1000. Therefore, one first wiring pattern 201 can be connected to a plurality of first-first pad patterns 202a and a plurality of first-second pad patterns 202b. A number of first-first pad patterns 202a connected to the first wiring pattern 201 is different from a number of first-second pad patterns 202b connected to the first wiring pattern 201. In detail, the number of first-first pad patterns 202a connected to the first wiring pattern 201 may be greater than the number of first-second pad patterns 202b connected to the first wiring pattern 201.

In detail, since a plurality of first-second pad patterns 202b are merged into one first wiring pattern 201, a current movement area can be expanded. In addition, the uniformity of the current moving to the plurality of first-second pad patterns 202b can be improved. Accordingly, the current transfer efficiency of the first flexible circuit board 1100 can be improved.

The first-second pad pattern 202b is formed with a set width. The first-second pad pattern 202b has a third width W3. The third width W3 is greater than the second-first width W1. In detail, the third width W3 can be 100 µm or more. Specifically, the third width W3 may range from 100 µm to 180 µm, 120 µm to 170 µm, or 130 µm to 150 µm.

The first-second pad pattern 202b may be merged into a plurality of first-second pad patterns 202b so that the first wiring pattern 201 can satisfy the width range.

The test pattern 300 is disposed at an edge of the substrate 100. Specifically, the test pattern 300 is disposed at the edge of the substrate 100 in the second direction 2D.

The test pattern 300 includes the second wiring pattern 301, the second-first pad pattern 302a, and the second-second pad pattern 302b. The second wiring pattern 301, the second-first pad pattern 302a, and the second-second pad pattern 202b includes a same material. The second wiring pattern 301, the second-first pad pattern 302a, and the second-second pad pattern 302b are formed integrally.

The second-first pad pattern 302a is disposed outside the protective layer 400. The second-first pad pattern 302a may be connected to the display panel 2000. Thus, the test pattern 300 is connected to the display panel 2000.

The second-second pad pattern 302b is disposed outside the protective layer 400. The second-second pad pattern 302b may be connected to the circuit board 3000. Thus, the test pattern 300 is connected to the circuit board 3000.

The second wiring pattern 301 is connected to at least one of the second-first pad pattern 302a and the second-second pad pattern 302b. The second wiring pattern 301 is a pattern through which current flows.

The test pattern 300 may include at least three patterns. For example, the test pattern 300 may include a first test pattern 310, a second test pattern 320, and a third test pattern 330.

At least one of the first test pattern 310, the second test pattern 320, and the third test pattern 330 may be connected to at least one of the display panel 2000 and the circuit board 3000.

For example, the first test pattern 310 and the second test pattern 320 are connected to the display panel 2000 and the circuit board 3000. In detail, the second wiring pattern of the first test pattern 310 and the second wiring pattern of the second test pattern 320 are connected to the second-first pad pattern 302a and the second-second pad pattern 302b. That is, the first test pattern 310 and the second test pattern 320 include the second wiring pattern, the second-first pad pattern 302a, and the second-second pad pattern 302b.

In addition, the third test pattern 330 is connected to one of the display panel 2000 and the circuit board 3000. In detail, the third test pattern 330 is connected to the display panel 2000. In detail, the second wiring pattern of the third test pattern 330 is connected to the second-first pad pattern 302a. That is, the third test pattern 330 includes the second wiring pattern and the second-first pad pattern 302a.

The first flexible circuit board 1100 can check the flow of current through the test pattern 300.

For example, when current is transmitted from the first flexible circuit board 1100 to the display panel 2000 and the circuit board 3000, the flow of current can be checked through the first test pattern 310 and the second test pattern 320.

Alternatively, when current is transmitted from the first flexible circuit board 1100 to the circuit board 3000, the flow of current can be checked through the first test pattern 310 and the second test pattern 320.

Alternatively, when current is transmitted from the first flexible circuit board 1100 to the display panel 2000, the current flow can be checked by the third test pattern 330.

Therefore, the current flow efficiency of the first flexible circuit board 1100 can be improved.

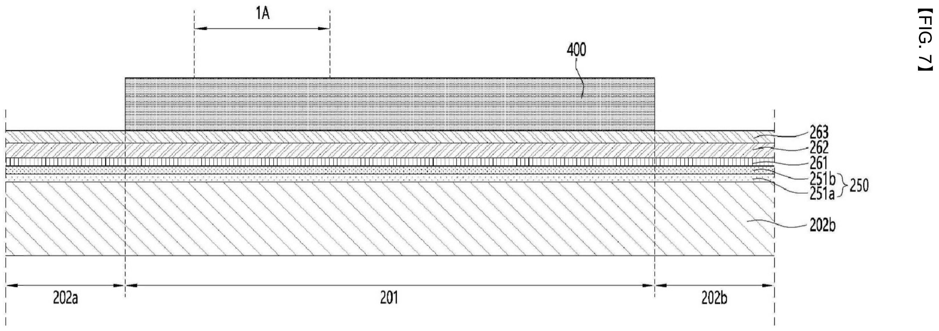

FIGS. 7 to 10 are various cross-sectional views taken along region A-A' of FIG. 4.

Referring to FIG. 7, the power pattern 200 and the test pattern 300 includes a metal. The power pattern 200 and the test pattern 300 comprise a same material. Accordingly, the following description will focus on the power pattern 200. Furthermore, the following description applies equally to the test pattern 300.

Referring to FIG. 7, the power pattern 200 may be formed in a plurality of layers. The first wiring pattern 201, the first-first pad pattern 202a, and the first-second pad pattern 202b may include a first metal layer 261 and a second metal layer 262.

The first metal layer 261 may be a seed layer of the power pattern 200. For example, the first metal layer 261 may include copper (Cu) and may be formed through electroless plating.

In addition, the second metal layer 262 may be a plating layer. For example, the second metal layer 262 may be a plating layer formed through electrolytic plating using the first metal layer 261 as a seed layer.

A thickness of the first metal layer 261 may be smaller than that of the second metal layer 262.

For example, the thickness of the first metal layer 261 may be 0.7 µm to 2 µm. In addition, the thickness of the second metal layer 262 may be 10 µm to 25 µm.

The first metal layer 261 and the second metal layer 262 may include the same metal material. For example, the first metal layer 261 and the second metal layer 262 may include copper (Cu).

In addition, a bonding layer 263 may be disposed on the second metal layer 261. The bonding layer 263 may be disposed on at least one of a side surface of the first metal layer 261, a side surface of the second metal layer 262, and an upper surface of the second metal layer 262. For example, the bonding layer 263 of the first wiring pattern 201 and the first-first pad pattern 202a is disposed on the upper surface of the second metal layer 262. In addition, the bonding layer 263 of the first-second pad pattern 202b is disposed on the side surface of the first metal layer 261, the side surface of the second metal layer 262, and the upper surface of the second metal layer 262.

The bonding layer 263 may include a metal. Specifically, the bonding layer 263 may include tin (Sn).

The bonding layer 263 may be formed to a thickness of 0.3 µm to 0.7 µm. A tin content of the bonding layer 263 may increase as it extends from the lower surface to the upper surface.

That is, the bonding layer 263 is disposed in contact with the second metal layer 262. Therefore, a tin content of the bonding layer 263 may increase and a copper content may decrease from the lower surface of the bonding layer 263 to the upper surface of the bonding layer 263.

Therefore, only pure tin may remain on the upper surface of the bonding layer 263 within a thickness range of 0.1 µm to 0.3 µm.

By the bonding layer 263, the first-first pad pattern 202a and the first-second pad pattern 202b can be easily connected to the terminals of the display panel and the circuit board. That is, when heat and pressure are applied to the pad pattern, the upper surface of the bonding layer, where pure tin remains, melts. As a result, the pad pattern, the terminal of the display panel, and the terminal of the circuit board can be easily bonded.

A thickness of the power pattern 200 may be 2 µm to 25 µm. For example, the thickness of the power pattern 200 may be 5 µm to 20 µm. For example, the thickness of the power pattern 200 may be 7 µm to 15 µm.

If the thickness of the power pattern 200 is less than 2 µm, the resistance of the power pattern 200 may increase. If the thickness of the power pattern 200 exceeds 25 µm, it may be difficult to implement a fine pattern.

The power pattern 200 may further include a buffer layer 250. The buffer layer 250 is disposed between the substrate 100 and the first metal layer 261. The buffer layer 250 may improve adhesion between the substrate 100 and the power pattern 200.

The buffer layer 250 may be formed in a plurality of layers. Specifically, a first buffer layer 251 and a second buffer layer 252 may be disposed on the substrate 100 and on the first buffer layer 251a. Accordingly, the first buffer layer 251 may be in contact with the substrate 100. In addition, the second buffer layer 252 may be in contact with the first metal layer 261.

The first buffer layer 251 may include a material having good adhesion to the substrate 100. For example, the first buffer layer 251 may include nickel (Ni). In addition, the second buffer layer 252 may include a material that exhibits excellent adhesion to the metal layer. For example, the second buffer layer 252 may include chromium (Cr).

The buffer layer 250 may have a thin film thickness in a nanometer range. For example, the thickness of the buffer layer 250 may be 20 nm or less.

The buffer layer 250 may enhance adhesion between the substrate 100 and the metal layer. This may prevent delamination of the power pattern.

Referring to FIG. 4, the first flexible circuit board 1100 may be defined by a first region 1A and a second region 2A.

The first region 1A and the second region 2A are defined as regions where the power pattern 200 and the test pattern 300 extend in a straight line. Specifically, the first region 1A and the second region 2A are defined as regions where the first wiring pattern 201 and the second wiring pattern 301 extend in a first direction 1D.

The first region 1A is adjacent to the first-first pad pattern 202a and the second-first pad pattern 302a. In addition, the second region 2A is adjacent to the first-second pad pattern 202b and the second-second pad pattern 302b.

The first flexible circuit board 1100 may be bent in at least one of the first region 1A and the second region 2A. Specifically, one region of the first region 1A may be bent. That is, the first region 1A may include a bending region.

Therefore, stress may be generated in the first region 1A. Furthermore, one region of the first wiring pattern 201 or one region of the second wiring pattern 301 may overlap the bending region.

Therefore, if the thickness of one region of the first wiring pattern 201 or one region of the second wiring pattern 301 overlapping the bending region is thick, the bending characteristics may be reduced.

Furthermore, a crack may be formed in one region of the first wiring pattern 201 or one region of the second wiring pattern 301 overlapping the bending region due to the stress.

Therefore, a layer structure of the wiring pattern may differ from a layer structure of the pad pattern.

Alternatively, the layer structure of one region of the wiring pattern overlapping the bending region may differ from the layer structure of another region.

The power pattern 200 and the test pattern 300 comprise a same material. Accordingly, the following description focuses on the power pattern 200. Furthermore, the description below applies equally to the test pattern 300.

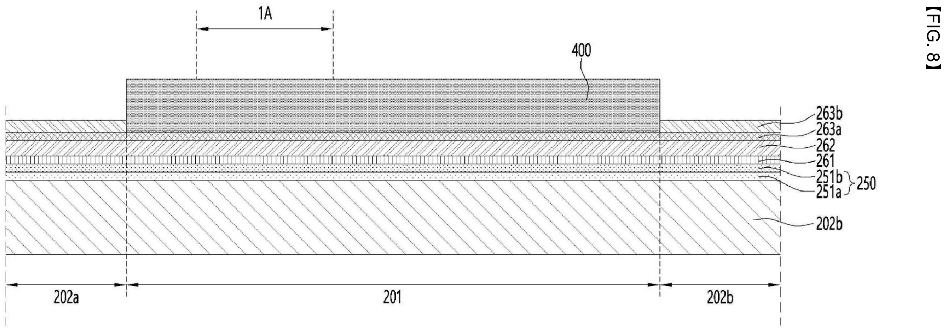

Referring to FIG. 8, a first flexible circuit board according to another embodiment will be described.

Referring to FIG. 8, the bonding layer 263 may include a plurality of bonding layers. For example, the bonding layer 263 may include a first bonding layer 263a and a second bonding layer 263b.

In detail, the first wiring pattern 201, the first-first pad pattern 202a, and the first-second pad pattern 202b may include the first bonding layer 263a. In addition, the first-first pad pattern 202a and the first-second pad pattern 202b may include the second bonding layer 263b.

The first bonding layer 263a and the second bonding layer 263b may include a metal. The first bonding layer 263a and the second bonding layer 263b may include a same metal. Specifically, the first bonding layer 263a and the second bonding layer 263b may include tin (Sn).

A thickness of the first bonding layer 263a and a thickness of the second bonding layer 263b may be different. Specifically, the thickness of the first bonding layer 263a may be smaller than the thickness of the second bonding layer 263b.

For example, the thickness of the first bonding layer 263a may be 0.02 µm to 0.06 µm. In addition, the thickness of the second bonding layer 263b may be 0.2 µm to 0.6 µm.

Accordingly, the thickness of the bonding layer disposed on the wiring pattern is smaller than the thickness of the bonding layer disposed on the pad pattern. In other words, the bonding layer disposed on the wiring pattern is formed with a thin film thickness.

The first region 1A overlaps the wiring pattern. Furthermore, only the first bonding layer is disposed on the wiring pattern.

Therefore, the first flexible circuit board can be easily bent. In addition, when bending the first flexible circuit board, cracks can be prevented from forming in the bonding layer in the region overlapping the bending region.

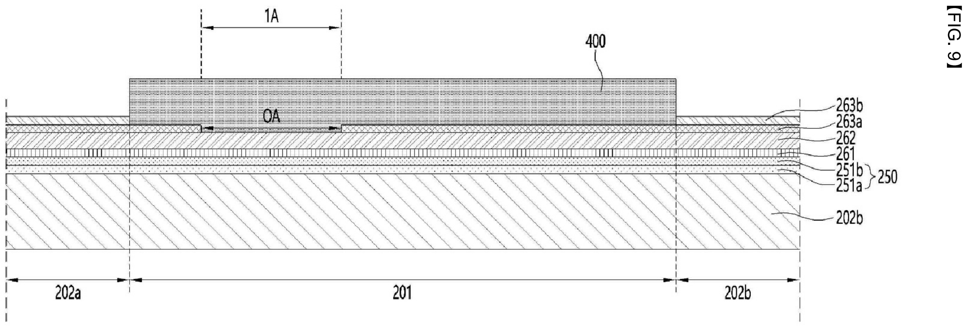

Referring to FIG. 9, a first flexible circuit board according to another embodiment will be described.

Referring to FIG. 9, the first wiring pattern 301 may include the first bonding layer 263a and the second bonding layer 263b.

The first bonding layer 263a is disposed on the metal layer 261 and 262. Specifically, the first bonding layer 263a is disposed on upper and side surfaces of the metal layer 261 and 262. The first bonding layer 263a is disposed on a partial region of the metal layer 261 and 262. The first bonding layer 263a is disposed while partially exposing the metal layer 261 and 262. As a result, an open region OA is formed on the metal layer 261 and 262.

The open region OA is disposed in a region corresponding to the first region 1A. For example, the open region OA is disposed in a region that entirely or partially corresponds to the first region 1A.

A protective layer 400 is disposed on the first bonding layer 263a. The protective layer 400 is disposed within the open region OA. Accordingly, the open region OA is filled with the protective layer 400.

The second bonding layer 263b is disposed on the first bonding layer 263a. The second bonding layer 263b is disposed on the upper and side surfaces of the first bonding layer 263a. That is, the second bonding layer 263b is not disposed on a region corresponding to the open region OA.

The first wiring pattern 201 of the first region 1A includes the open region OA. Furthermore, a protective layer 400 comprising a resin material is disposed within the open region OA.

Therefore, the first flexible circuit board can be easily bent. Furthermore, when bending the first flexible circuit board, cracks in the bonding layer due to the open region can be prevented. That is, the first region includes the open region, and the bonding layer is not disposed in the open region. Therefore, when bending the first flexible circuit board, cracks can be prevented from forming in the bonding layer due to stress.

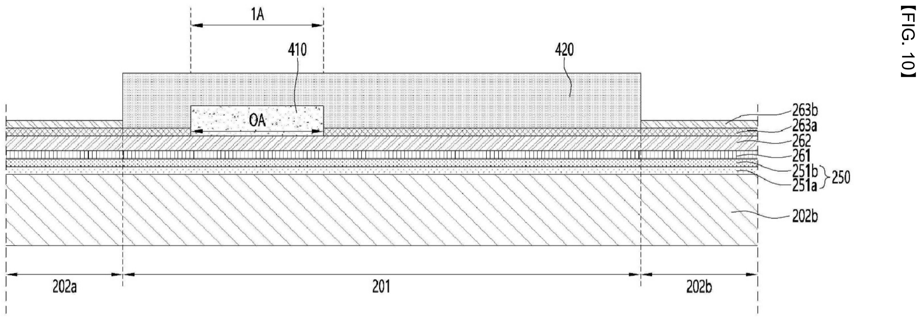

Referring to FIG. 10, a first flexible circuit board according to another embodiment will be described.

Referring to FIG. 10, the first wiring pattern 301 may include the first bonding layer 263a and the second bonding layer 263b.

The first bonding layer 263a is disposed on the metal layers 261 and 262. Specifically, the first bonding layer 263a is disposed on upper and side surfaces of the metal layers 261 and 262. The first bonding layer 263a is disposed while partially exposing the metal layers 261 and 262. As a result, an open region OA is formed on the metal layers 261 and 262.

A first protective layer 410 is disposed on the open region OA. The first protective layer 410 is disposed in the open region OA. The first protective layer 410 contacts upper surfaces of the metal layers 261 and 262. Accordingly, the open region OA is filled by the protective layer 400.

The second bonding layer 263b is disposed on the first bonding layer 263a. The second bonding layer 263b is disposed on upper surface and side surfaces of the first bonding layer 263a.

The second protective layer 420 is disposed on the first bonding layer 263a. The second protective layer 420 is disposed on the first protective layer 410. The second protective layer 420 overlaps the open region OA.

The first wiring pattern 201 includes an open region OA. Furthermore, the first protective layer 410 and the second protective layer 420, each containing a resin material, are disposed in the open region OA.

Therefore, the first flexible circuit board can be easily bent. Furthermore, when bending the first flexible circuit board, cracks in the bonding layer due to the open region can be prevented. Specifically, the first region includes the open region, and the bonding layer is not disposed in the open region. Furthermore, two protective layers are disposed in the open region. Therefore, when bending the first flexible circuit board, cracks in the bonding layer due to stress can be prevented.

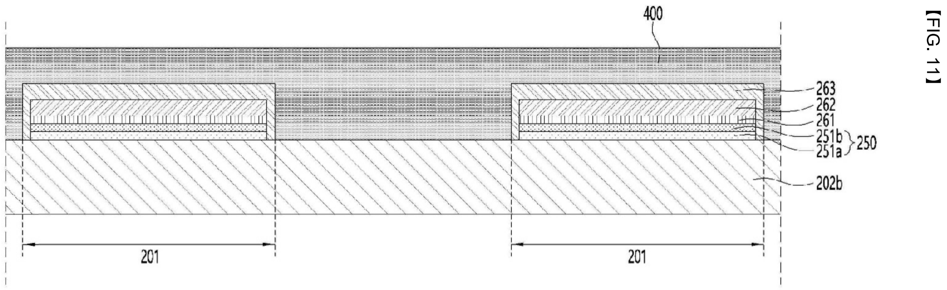

FIGS. 11 to 18 are cross-sectional views of the first flexible circuit board having the layer structure of FIGS. 7 to 10.

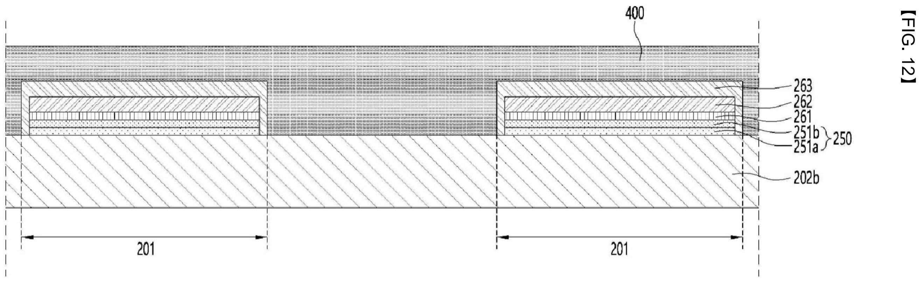

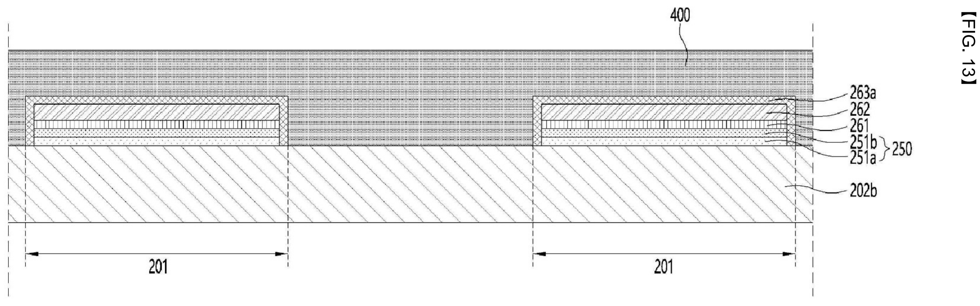

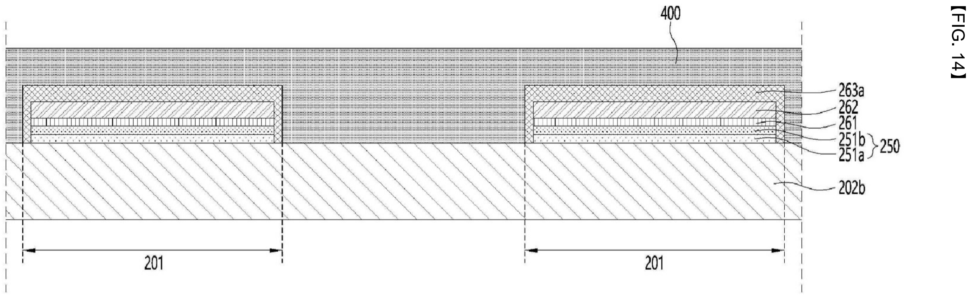

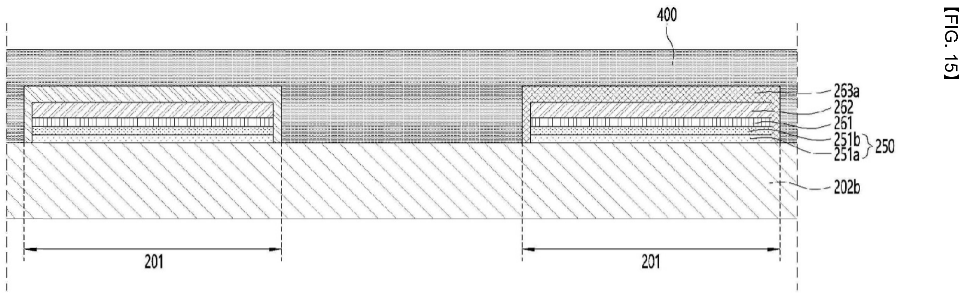

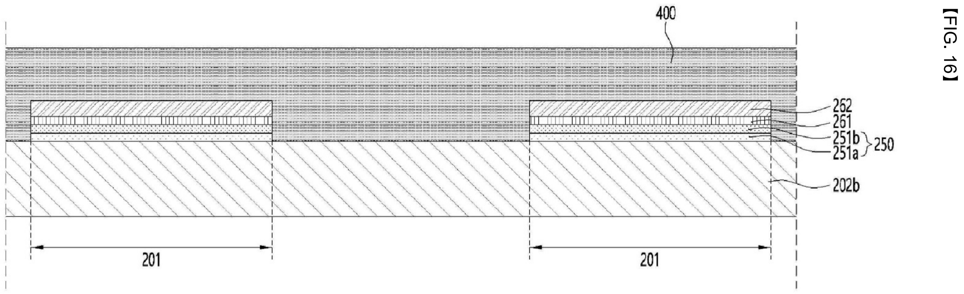

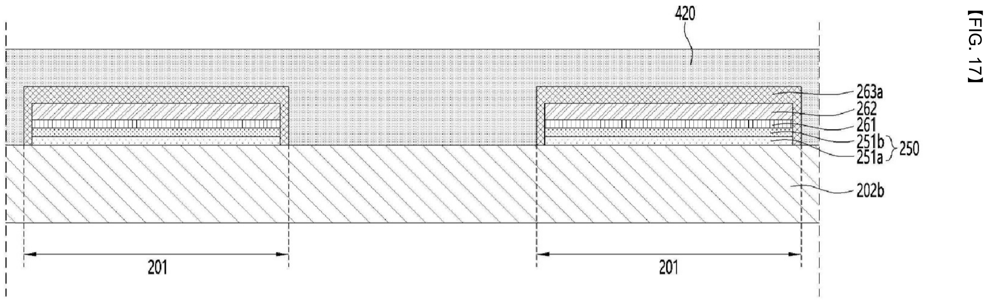

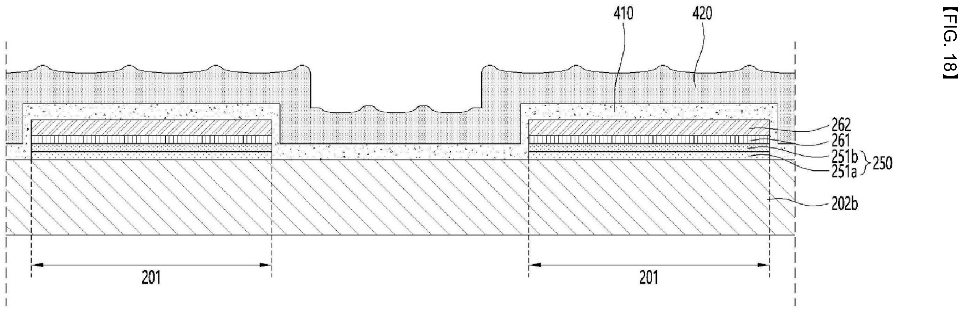

FIGS. 11 and 12 are cross-sectional views of a case having the layer structure of FIG. 7. FIGS. 13 and 14 are cross-sectional views of a case having the layer structure of FIG. 8. FIGS. 15 and 16 are cross-sectional views of a case having the layer structure of FIG. 9. FIGS. 17 and 18 are cross-sectional views of a case having the layer structure of FIG. 10.

FIGS. 11, 13, 15, and 17 are cross-sectional views of regions other than the first region, and FIGS. 12, 14, 16, and 18 are cross-sectional views of the first region.

Referring to FIGS. 11 and 12, the layer structures of the first region and regions other than the first region may be identical. Specifically, the bonding layer 263 and the protective layer 400 may be disposed on the second metal layer 262 in the first region and regions other than the first region.

Referring to FIGS. 13 and 14, the layer structures of the first region and regions other than the first region may be the same. Specifically, the first bonding layer 263a and the protective layer 400 may be disposed on the second metal layer 262 in the first region and regions other than the first region. Specifically, the thickness of the first bonding layer 263a is smaller than the thickness of the second bonding layer 263b, and the second bonding layer 263b may be disposed only on the first-first pad pattern 202a and the first-second pad pattern 202b.

Referring to FIGS. 15 and 16, the layer structures of the first region and regions other than the first region may be different. Referring to FIG. 15, the first bonding layer 263a and the protective layer 400 may be disposed on the second metal layer 262 in regions other than the first region. Furthermore, referring to FIG. 16, the protective layer 400 may be disposed on the second metal layer 262. Specifically, the thicknesses of the first bonding layer 263a and the second bonding layer 263b may be the same or similar, and the first bonding layer 263a may be disposed on regions other than the first region. Furthermore, the second bonding layer 263b may be disposed only on the first-first pad pattern 202a and the first-second pad pattern 202b.

Referring to FIGS. 17 and 18, the layer structures of the first region and regions other than the first region can be different. Referring to FIG. 17, the first bonding layer 263a and the second protective layer 420 may be disposed on the second metal layer 262 in a region other than the first region. In addition, referring to FIG. 18, the first protective layer 410 and the second protective layer 420 may be disposed on the second metal layer 262. In detail, the thickness of the first bonding layer 263a and the thickness of the second bonding layer 263b are the same or similar, and the first bonding layer 263a may be disposed on a region other than the first region. In addition, the second bonding layer 263b may be disposed only on the first-first pad pattern 202a and the first-second pad pattern 202b. In addition, the second protective layer 420 is disposed on the first region.

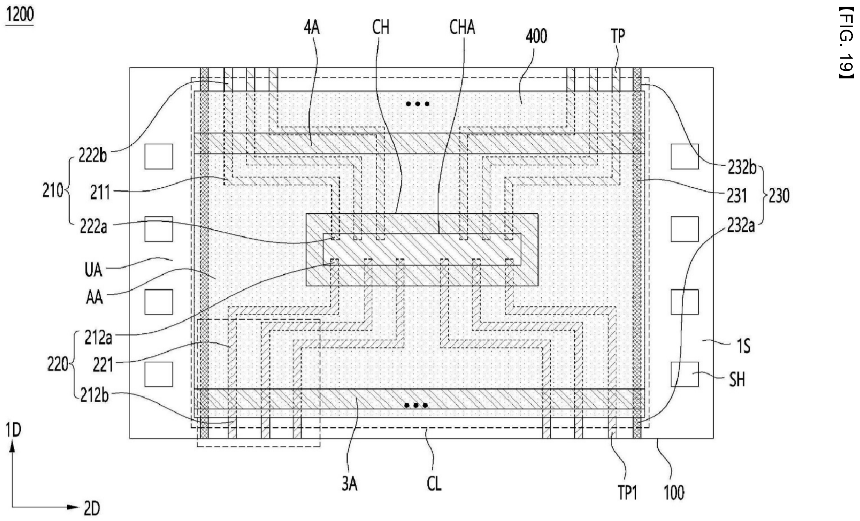

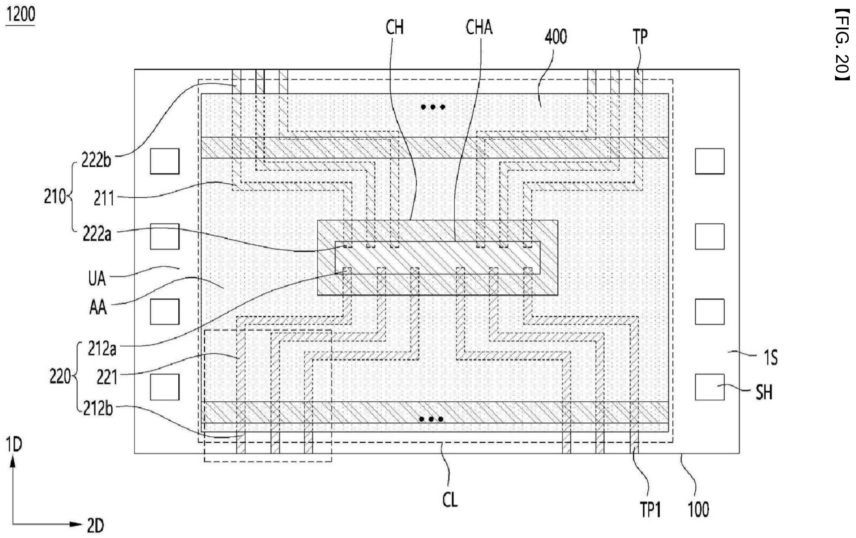

Hereinafter, the second flexible circuit board 1200 will be described with reference to FIGS. 19 and 20.

The second flexible circuit board 1200 includes a substrate 100, a circuit pattern, a chip CH, and a protective layer 400.

The substrate 100 includes a first surface 1S and a second surface 2S opposite the first surface 1S. The circuit pattern and the protective layer 400 are disposed on the first surface 1S.

The substrate 100 includes a cutting line CL. The first flexible circuit board 1100 is cut along the cutting line CL. For example, the circuit pattern and the protective layer 400 are first disposed on the substrate 100. Subsequently, the substrate 100 is cut along the cutting line CL.

The substrate 100 includes a valid region AA and an invalid region UA. Specifically, the first surface 1S includes the valid region AA and the invalid region UA.

The valid region AA and the invalid region UA are separated by the cutting line CL. Specifically, the valid region AA is defined as the inner region of the cutting line CL. In addition, the invalid region UA is defined as the outer region of the cutting line CL.

The circuit pattern and the protective layer are disposed in the valid region AA. Furthermore, a dummy pattern and a sprocket hole SH are disposed in the invalid region UA. The dummy pattern increases the strength of the substrate 100. Furthermore, the flexible circuit board 1000 is rolled or unrolled in a roll-to-roll manner by the sprocket hole SH.

The substrate 100 includes a chip mounting region CHA. The chip mounting region CHA is disposed on the first surface 1S. The chip mounting region CHA is disposed in the valid region AA. The chip CH is disposed in the chip mounting region CHA. Furthermore, pad parts of the circuit pattern are disposed in the chip mounting region CHA. Furthermore, the protective layer is not disposed on the chip mounting region CHA.

The material and thickness of the substrate 100 are the same as those of the first flexible circuit board. Therefore, a detailed description thereof will be omitted.

The circuit pattern and the protective layer 400 are disposed on the substrate 100. Specifically, the circuit pattern and the protective layer 400 are disposed on the first surface 1S. Specifically, the circuit pattern and the protective layer 400 are disposed on at least one of the valid region AA and the invalid region UA.

The circuit pattern includes at least one of a first circuit pattern 210, a second circuit pattern 220, and a third circuit pattern 230.

Referring to FIG. 19, the second flexible circuit board 1200 includes the first circuit pattern 210 and the second circuit pattern 220.

The first circuit pattern 210 includes a first wiring part 211, a first pad part 212a, and a second pad part 212b. The first wiring part 211, the first pad part 212a, and the second pad part 212b may include a same material. In addition, the first wiring part 211, the first pad part 212a, and the second pad part 212b may be formed integrally.

The first pad part 212a is disposed within the chip mounting region CHA. Accordingly, the first pad part 212a can be connected to the terminal of the chip. Thus, the first circuit pattern 210 and the chip can be connected.

In addition, the second pad part 212b is disposed outside the chip mounting region CHA. The second pad part 212b can be connected to the display panel 2000. Thus, the first circuit pattern 210 can be connected to the display panel 2000.

In addition, the first wiring part 211 is disposed between the first pad part 212a and the second pad part 212b. That is, the first wiring part 211 connects the first pad part 212a and the second pad part 212b. Thus, the chip CH and the display panel 2000 are connected. Accordingly, the signal generated from the chip CH is transmitted to the display panel 2000.

The first circuit pattern 210 may include a test pad part. Specifically, a first test pad part TP1 is disposed in the invalid region UA. The first wiring part 211, the first pad part 212a, the second pad part 212b, and the first test pad part TP1 may be formed integrally.

The first circuit pattern 210 may be tested before connecting the circuit board and the second pad part 212b. For example, the first test pad part TP1 can be used to check for open and short circuits in the first circuit pattern.

The second circuit pattern 220 includes a second wiring part 221, a third pad part 222a, and a fourth pad part 222b. The second wiring part 221, the third pad part 222a, and the fourth pad part 222b may include a same material. Furthermore, the second wiring part 221, the third pad part 222a, and the fourth pad part 222b may be formed integrally.

The third pad part 222a is disposed inside the chip mounting region CHA. Accordingly, the third pad part 222a may be connected to a terminal of the chip CH. Thus, the second circuit pattern 220 and the chip CH may be connected.

Furthermore, the fourth pad part 222b is disposed outside the chip mounting region CHA. The fourth pad part 222b may be connected to the circuit board 3000. Accordingly, the second circuit pattern 220 and the circuit board 3000 can be connected.

In addition, the second wiring part 221 is disposed between the third pad part 222a and the fourth pad part 222b. That is, the second wiring part 221 connects the third pad part 222a and the fourth pad part 222b. Accordingly, the chip CH and the circuit board 3000 are connected. Accordingly, a signal generated from the chip is transmitted to the circuit board 3000.

The second circuit pattern 220 may further include a test pad part. Specifically, a second test pad part TP2 is disposed in the invalid region UA. The second wiring part 221, the third pad part 222a, the fourth pad part 222b, and the second test pad part TP2 may be formed integrally.

The second circuit pattern 220 may be tested before connecting the circuit board and the fourth pad part 222b. For example, the second test pad part TP2 can be used to check for open and short circuits in the second circuit pattern.

The third circuit pattern 230 includes a third wiring part 231, a fifth pad part 232a, and a sixth pad part 232b. The third wiring part 231, the fifth pad part 232a, and the sixth pad part 232b may include a same material. Furthermore, the third wiring part 231, the fifth pad part 232a, and the sixth pad part 232b may be formed integrally.

The fifth pad part 232a and the sixth pad part 232b are disposed outside the chip mounting region CHA. The fifth pad part 232a may be connected to the display panel 2000. Furthermore, the sixth pad part 232b may be connected to the circuit board 2000.

Furthermore, the third wiring part 231 is disposed between the fifth pad part 232a and the sixth pad part 232b. That is, the third wiring part 231 connects the fifth pad part 232a and the sixth pad part 232b. Accordingly, the circuit board and the display panel are connected.

The third circuit pattern 230 serves a same function as the power pattern of the first flexible circuit board 1110. That is, the third circuit pattern 230 can supply power to at least one of the display panel and the circuit board.

A line width and spacing of the third circuit pattern 230 may be greater than those of the first circuit pattern 210. In addition, the line width and spacing of the third circuit pattern 230 may be greater than those of the second circuit pattern 220.

In addition, a width of the third wiring part 231 is different from that of the first wiring pattern. Specifically, the width of the third wiring part 231 is smaller than the width of the first wiring pattern. The second flexible circuit board 1200 includes the chip CH. Furthermore, the second flexible circuit board 1200 includes the chip, the first circuit pattern 210, and the second circuit pattern 220 connected to the chip CH.

Therefore, an area where the third wiring part 231 is disposed is limited. Accordingly, the width of the third wiring part 231 is smaller than the width of the first wiring pattern.

The protective layer 400 is disposed on the first surface 1S. Accordingly, the protective layer 400 is disposed on the first circuit pattern 210, the second circuit pattern 220, and the third circuit pattern 230. The protective layer 400 is disposed on a region excluding the first pad part 212a, the second pad part 212b, the third pad part 222a, the fourth pad part 222b, the fifth pad part 232a, and the sixth pad part 232b.

Referring to FIG. 20, the second flexible circuit board 1200 does not include the third circuit pattern 230. Specifically, the second flexible circuit board 1200 does not include a pattern that supplies power to the display panel 2000 and/or the circuit board 3000.

Therefore, a size of the second flexible circuit board 1200 can be reduced.

Furthermore, a region where the first circuit pattern 210 and the second circuit pattern 220 are disposed can be increased. Accordingly, the line width or spacing of the first circuit pattern 210 and the second circuit pattern 220 can be controlled. This prevents short circuiting of the first circuit pattern 210 and the second circuit pattern 220.

Therefore, the reliability of the second flexible circuit board is improved.

Furthermore, power can be supplied to the display panel and the circuit board only from the first flexible circuit board. This eliminates the need to drive the first flexible circuit board and the second flexible circuit board separately.

Furthermore, the second flexible circuit board does not include a third circuit pattern having a large width. Therefore, when forming the circuit pattern of the second flexible circuit board, a line width difference of the pattern can be reduced due to a line width difference.

Referring to FIGS. 19 and 20, the second flexible circuit board 1200 can have a third region 3A and a fourth region 4A defined.

The third region 3A is adjacent to the second pad part 212b. In addition, the fourth region 4A is adjacent to the fourth pad part 222b.

The second flexible circuit board 1200 may be bent in at least one of the third region 3A and the fourth region 4A. Specifically, one region of the third region 3A may be bent. That is, the third region 3A may include a bending region.

Therefore, stress may be generated in the third region 3A. In addition, one region of the first wiring part 221 may overlap the bending region.

Therefore, if the thickness of one region of the first wiring part 221 overlapping the bending region is thick, the bending characteristic may be reduced.

In addition, a crack may be formed in a region of the first wiring part 221 that overlaps the bending region due to the stress.

Therefore, the layer structure of a region of the first wiring part overlapping the bending region may be different from the layer structures of other regions.

For example, the layer structure of a region of the first wiring part overlapping the bending region may be identical to or similar to the layer structure of a region of the wiring pattern as described above in FIGS. 7 to 18.

Therefore, when bending the second flexible circuit board, cracks can be prevented from occurring in the bonding layer due to stress.

A flexible circuit board module according to an embodiment includes a first flexible circuit board and a second flexible circuit board.

The first flexible circuit board includes a power pattern. Power can be stably supplied to the display panel by the power pattern.

The power pattern is connected to a plurality of pad patterns. Accordingly, the current flow efficiency of the power pattern is improved.

Furthermore, the first flexible circuit board includes a test pattern. The test pattern allows the first flexible circuit board to check the current flow before use. Accordingly, the reliability of the electronic device is improved.

Furthermore, the first flexible circuit board includes a first region and a second region. The first region can be bent. The layer structure of the wiring pattern overlapping the first region may be different from the layer structures of the other regions. Accordingly, the bending reliability of the first flexible circuit board is improved.

The second flexible circuit board may omit the power supply pattern. Accordingly, the size of the second flexible circuit board can be reduced. Furthermore, the uniformity of the pattern disposed on the second flexible circuit board is improved.

Because the flexible circuit board module is flexible, it can be used in various electronic devices.

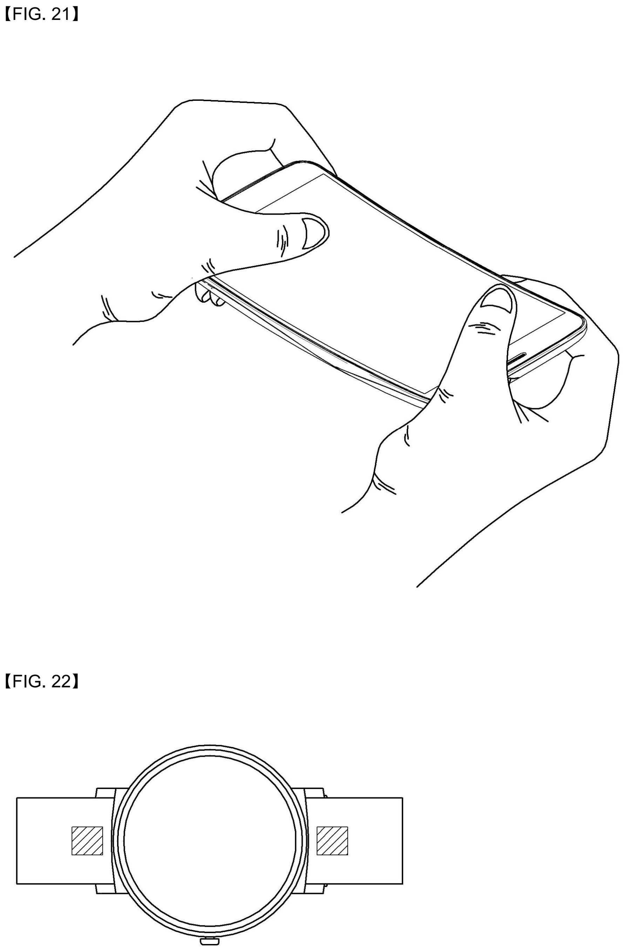

For example, referring to FIG. 21, the flexible circuit board module can be applied to a flexible touch device. Therefore, a user can bend or fold the touch device by hand.

Referring to FIG. 22, the flexible circuit board module can be applied to a wearable touch device including a curved display.

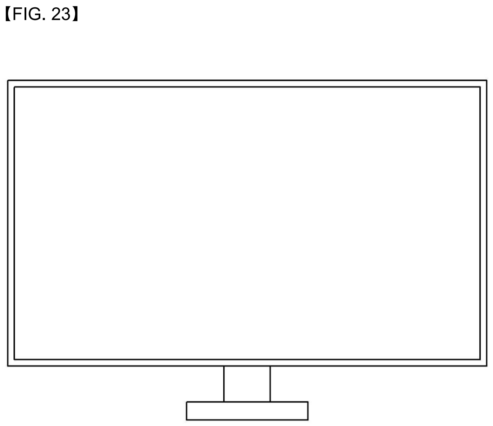

Referring to FIG. 23, the flexible circuit board module can be applied to various electronic devices with display portions, such as TVs, monitors, and laptops. The flexible circuit board module can also be used in electronic devices with curved display portions.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A flexible circuit board module comprising:
a first flexible circuit board and a second flexible circuit board,
wherein the first flexible circuit board includes:
a substrate;
a power pattern and a test pattern disposed on the substrate; and
a protective layer disposed on the power pattern and the test pattern,
wherein the power pattern includes a first wiring pattern, a first-first pad pattern, and a first-second pad pattern,
wherein the first-first pad pattern is connected to a display panel,
wherein the first-second pad pattern is connected to a circuit board, and
wherein a first width of the first wiring pattern is 1 mm to 3 mm.

2. The flexible circuit board module of claim 1, wherein the first wiring pattern is connected to a plurality of first-first pad patterns and a plurality of first-second pad patterns.

3. The flexible circuit board module of claim 1, wherein the first-first pad pattern has a second-first width and a second-second width,
wherein the second-first width is 15 µm to 25 µm, and
wherein the second-second width is 3 µm to 14 µm.

4. The flexible circuit board module of claim 1, wherein a third width of the first-second pad pattern is 100 µm to 180 µm.

5. The flexible circuit board module of claim 1, wherein the test pattern includes a second wiring pattern, a second-first pad pattern, and a second-second pad pattern,
wherein the test pattern includes a first test pattern, a second test pattern, and a third test pattern,
wherein the first test pattern and the second test pattern include the second wiring pattern, the second-first pad pattern, and the second-second pad pattern, and
wherein the third test pattern includes the second wiring pattern and the second-first pad pattern.

6. The flexible circuit board module of claim 1, wherein the first flexible circuit board defines a first region,
wherein the first region is defined as a region in which the first wiring pattern extends in a linear direction,
wherein the first region is adjacent to the first-first pad pattern, and
wherein one region of the first region is bent.

7. The flexible circuit board module of claim 6, wherein the first wiring pattern includes a first bonding layer,
wherein the first-first pad pattern and the first-second pad pattern include the first bonding layer and a second bonding layer,
wherein the first bonding layer and the second bonding layer include tin, and
wherein a thickness of the first bonding layer is smaller than a thickness of the second bonding layer.

8. The flexible circuit board module of claim 6, wherein the first wiring pattern includes a metal layer and a bonding layer on the metal layer,
wherein the bonding layer is disposed in a partial region of the metal layer,
wherein an open region is formed on the metal layer by the first bonding layer, and
wherein the protective layer is disposed in the open region.

9. The flexible circuit board module of claim 8, wherein the protective layer includes a first protective layer disposed in the open region; and a second protective layer on the first protective layer.

10. The flexible circuit board module of claim 1, wherein the second flexible circuit board comprises:
a substrate;
a circuit pattern disposed on the substrate; and
a protective layer disposed on the circuit pattern,
wherein the circuit pattern includes a first circuit pattern connected to a chip and the display panel; and a second circuit pattern connected to the chip and the circuit board.
